# DEMANDE DE BREVET EUROPEEN

(11) **EP 2 919 261 A1**
(43) Date de publication de la demande: **16.09.2015**
(21) Numéro de dépôt: 15158423.2
(22) Date de dépôt: 10.03.2015
(51) Int. Cl.: H01L 21/60, H01L 23/485

(54) **Procédé d'hybridation par collage de deux éléments microélectroniques**

(30) Priorité: 11.03.2014 FR 1451996
(71) Demandeur: COMMISSARIAT A L'ENERGIE ATOMIQUE ET AUX ENERGIES ALTERNATIVES, 75015 Paris (FR); RENAULT S.A.S., 92100 Boulogne Billancourt (FR)
(72) Inventeur: Chambion, Bertrand, 38400 SAINT MARTIN D'HERES (FR); Bedoin, Alexis, 42230 SAINT VICTOR SUR LOIRE (FR)
(74) Mandataire: Novaimo

(57) **Abrégé**

Le procédé d'hybridation d'un premier élément microélectronique (100) avec un deuxième élément microélectronique (200) comporte une étape de rapprochement des premier et deuxième éléments microélectroniques (100, 200) de telle sorte à générer un collage par interaction de premier et deuxième composants (104, 202) d'une colle bi-composants. Au moins un premier organe (103) s'étend dudit premier élément microélectronique (100), le premier composant (104) de la colle bi-composants étant associé audit premier élément microélectronique (100), et au moins un deuxième organe (201) s'étend dudit deuxième élément microélectronique (200), le deuxième composant (202) de la colle bi-composants étant associé audit deuxième élément microélectronique (200). Le procédé comporte une étape de mélange des premier et deuxième composants (104, 202) mise en oeuvre par lesdits au moins un premier et deuxième organes (103, 201) lors de l'étape de rapprochement, et en ce qu'au terme de l'étape de rapprochement la distance (d1) séparant le premier élément microélectronique (100) du deuxième élément microélectronique (200) est inférieure à la hauteur cumulée dudit au moins un premier organe (103) et dudit au moins un deuxième organe (201) avant rapprochement.

## Description

### Domaine technique de l'invention

L'invention concerne le domaine de la microélectronique et plus particulièrement de l'hybridation de deux éléments microélectroniques dont préférentiellement au moins un comporte une puce électronique.

L'invention a pour objet plus particulièrement un procédé d'hybridation d'un premier élément microélectronique avec un deuxième élément microélectronique, au moins un premier organe s'étendant dudit premier élément microélectronique, un premier composant d'une colle bi-composants étant associé audit premier élément microélectronique, au moins un deuxième organe s'étendant dudit deuxième élément microélectronique, un deuxième composant de la colle bi-composants étant associé audit deuxième élément microélectronique, ledit procédé comportant une étape de rapprochement des premier et deuxième éléments microélectroniques de telle sorte à générer un collage par interaction des premier et deuxième composants de la colle bi-composants.

### État de la technique

Dans le domaine de la microélectronique, il est courant de devoir hybrider deux supports distincts dont préférentiellement au moins un intègre une puce électronique.

L'hybridation des deux supports doit être améliorée en termes de robustesse de sorte à éviter toute séparation de ces derniers. En ce sens, il est connu de réaliser un collage.

Un tel procédé d'hybridation mettant en oeuvre un collage est décrit dans le document EP0982385. Dans ce document, un substrat est équipé d'électrodes destinées à être connectées à des plots d'un composant fonctionnel. Avant assemblage du substrat avec le composant fonctionnel, les électrodes sont recouvertes par un premier composant d'une colle bi-composants et les plots sont recouverts par un deuxième composant de la colle bi-composants. Lors de l'assemblage, le substrat et l'élément fonctionnel sont rapprochés de telle sorte que les premier et deuxième composants de la colle bi-composants interagissent entre eux pour fixer l'assemblage.

### Objet de l'invention

Le but de la présente invention est de proposer une solution permettant d'améliorer la qualité du collage, en termes de robustesse et/ou de fiabilité.

On tend vers ce but en ce que le procédé comporte une étape de mélange des premier et deuxième composants mise en oeuvre par lesdits au moins un premier et deuxième organes lors de l'étape de rapprochement, et en ce qu'au terme de l'étape de rapprochement la distance séparant le premier élément microélectronique du deuxième élément microélectronique est inférieure à la hauteur cumulée dudit au moins un premier organe et dudit au moins un deuxième organe avant rapprochement.

Préférentiellement, l'étape de rapprochement est stoppée lorsque le rapport de la distance séparant les premier et deuxième éléments microélectroniques sur la hauteur cumulée dudit au moins un premier organe et dudit au moins un deuxième organe avant rapprochement est inférieur à 0,9, et de préférence compris entre 0,1 et 0,9.

Selon une mise en oeuvre, ledit au moins un premier organe étant recouvert par le premier composant et/ou ledit au moins un deuxième organe étant recouvert par le deuxième composant, le procédé comporte une étape d'insertion dudit au moins un premier organe dans ledit au moins un deuxième organe correspondant, ou dudit au moins un deuxième organe dans ledit au moins un premier organe correspondant, ladite étape d'insertion étant réalisée au cours de l'étape de rapprochement.

Selon une réalisation, le procédé comporte une étape de connexion électrique dudit au moins un premier organe avec ledit au moins un deuxième organe mise en oeuvre par l'étape d'insertion, préférentiellement ledit au moins un premier organe étant relié électriquement à au moins une puce électronique du premier élément microélectronique.

Avantageusement, au moins l'un des premier ou deuxième organe comporte un corps creux rempli par le composant correspondant de la colle, et le procédé comporte une étape d'expulsion d'au moins une partie dudit composant correspondant de la colle hors du corps creux mise en oeuvre au cours de l'étape d'insertion.

De préférence, le premier élément microélectronique comporte une pluralité de premiers organes recouverts par le premier composant et le deuxième élément microélectronique comporte une pluralité de deuxièmes organes recouverts par le deuxième composant, et l'étape de mélange est telle que les premier et deuxième composants se mélangent par écoulement forcé de ces derniers au travers d'obstacles formés par les premiers organes et les deuxièmes organes.

En outre, le procédé peut comporter une étape de chauffage mise en oeuvre avant, ou au cours de, l'étape de rapprochement et configurée de sorte à modifier la viscosité du premier composant et/ou du deuxième composant.

Préférentiellement, le procédé comporte une étape de formation du premier composant et une étape de formation du deuxième composant.

L'étape de formation du premier composant peut comporter :
- une étape de formation d'un mélange dudit premier composant avec un solvant inerte vis-à-vis dudit premier composant,
- une étape de dépôt du mélange sur le premier élément microélectronique,
- une étape d'évaporation du solvant compris dans le mélange déposé.

L'étape de formation du deuxième composant peut comporter :
- une étape de formation d'un mélange dudit deuxième composant avec un solvant inerte vis-à-vis dudit deuxième composant,
- une étape de dépôt du mélange sur le deuxième élément microélectronique,
- une étape d'évaporation du solvant compris dans le mélange déposé.

L'étape d'évaporation peut être mise en oeuvre par un cycle thermique appliqué au mélange déposé.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue en coupe transversale d'un premier élément microélectronique et d'un deuxième élément microélectronique avant hybridation,
- la figure 2 représente une variante de la figure 1,
- la figure 3 illustre une vue en coupe transversale des éléments de la figure 1 une fois hybridés,
- la figure 4 représente la figure 2 en configuration d'hybridation,
- la figure 5 représente une vue en coupe transversale d'un mode d'exécution particulier d'un premier élément microélectronique et d'un deuxième élément microélectronique hybridés,
- la figure 6 représente les formes adoptées par un premier organe et un deuxième organe,
- la figure 7 illustre une variante de la figure 2.

### Description de modes préférentiels de l'invention

Le procédé d'hybridation diffère de l'art antérieur en ce qu'il va être mis en oeuvre de telle sorte à favoriser le mélange des deux composants de la colle bi-composants.

Par « procédé d'hybridation », on entend le sens large du terme hybridation dans le sens où il s'agit de réunir deux éléments distincts, par exemple mais non seulement, réalisés dans des technologies différentes, notamment pour former un système monobloc.

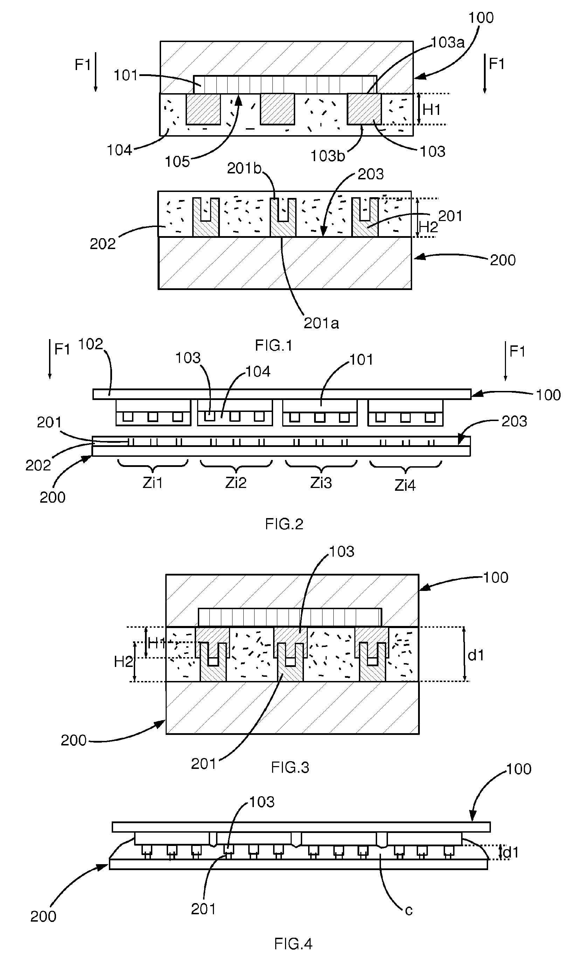

Comme illustré à la figure 1, le procédé permet l'hybridation d'un premier élément microélectronique 100 avec un deuxième élément microélectronique 200.

Par « premier élément microélectronique et deuxième élément microélectronique », on entend de manière large tout type d'élément dont tout ou partie est réalisée en utilisant des techniques de la microélectronique.

L'un et/ou l'autre des éléments microélectroniques 100, 200 peuvent être muni d'une puce électronique 101.

Par « puce électronique », on entend notamment un circuit intégré par exemple réalisé en utilisant les technologies de la microélectronique voire de la nanoélectronique.

A titre d'exemple, le premier élément microélectronique 100 peut être constitué par la puce électronique 101, ou, comme à la figure 2, être assimilé à une plaquette de silicium comportant une pluralité de puces électroniques 101 individualisées ou non. A la figure 2, le deuxième élément microélectronique 200 va permettre une hybridation avec chacune d'une ou plusieurs puces électroniques 101 appartenant notamment au premier élément microélectronique 100.

Lorsque les puces électroniques 101 ne sont pas individualisées, elles sont toutes intégrées à un support telle une plaquette, aussi connue sous le terme anglais de wafer dans le domaine, ou encore une dalle dans le domaine des écrans.

Lorsque les puces électroniques sont individualisées (figure 2), le premier élément microélectronique 100 peut comporter un film 102 sur lequel sont solidarisées toutes les puces électroniques notamment par collage. Le film est généralement collé sur une face arrière d'une plaquette avant découpe des puces, la découpe des puces permettant leur individualisation.

De manière générale, au moins un premier organe 103 s'étend dudit premier élément microélectronique 100 et un premier composant 104 d'une colle bi-composants est associé audit premier élément microélectronique 100. Au moins un deuxième organe 201 s'étend dudit deuxième élément microélectronique 200, et un deuxième composant 202 de la colle bi-composants est associé au deuxième élément microélectronique 200.

De préférence, plusieurs premiers organes 103 s'étendent du premier élément microélectronique 100. Dans la présente description, tout ce qui s'applique à un premier organe 103 peut s'appliquer à chacun des premiers organes 103. De manière analogue, plusieurs deuxièmes organes 201 peuvent s'étendre du deuxième élément microélectronique 200, et tout ce qui s'applique dans la présente description à un deuxième organe 201 peut s'appliquer à chacun des deuxièmes organes 201.

La notion d'association du premier composant 104 au premier élément microélectronique 100 est à prendre au sens large. Cette association peut être telle que le premier composant 104 recouvre ledit au moins un premier organe 103, notamment en tout ou partie, et/ou le premier élément microélectronique 100, notamment au niveau d'une face 105 dudit premier élément microélectronique 100 à partir de laquelle s'étend ledit au moins un premier organe 103.

La notion d'association du deuxième composant 202 au deuxième élément microélectronique 200 est aussi à prendre au sens large. Cette association peut être telle que le deuxième composant 202 recouvre ledit au moins un deuxième organe 201, notamment en tout ou partie, et/ou le deuxième élément microélectronique 200, notamment au niveau d'une face 203 dudit deuxième élément microélectronique 200 à partir de laquelle s'étend ledit au moins un deuxième organe 201.

En outre, le procédé comporte une étape de rapprochement (selon les flèches F1) des premier et deuxième éléments microélectroniques 100, 200 de telle sorte à générer un collage par interaction des premier et deuxième composants 104, 202 de la colle bi-composants. En outre, le procédé comporte une étape de mélange des premier et deuxième composants 104, 202 mise en oeuvre par lesdits au moins un premier et deuxième organes 103, 201 lors de l'étape de rapprochement.

On comprend ici que l'interaction entre les premier et deuxième organes 103, 201 (avec ou sans contact de ces derniers) lors du rapprochement est telle qu'elle provoque un écoulement forcé dudit premier composant 104 et/ou dudit deuxième composant 202. Il résulte de l'écoulement un mélange amélioré des premier et deuxième composants 104, 202 de la colle bi-composants.

En particulier, l'interaction des premier et deuxième composants n'est pas ici mise en oeuvre dans des plans, il en résulte une meilleure robustesse dans le collage. Pour obtenir ce résultat, il est préférable que les hauteurs dudit au moins un premier organe et dudit au moins un deuxième organe soient sensiblement égales. Par « hauteurs sensiblement égales » on entend que les hauteurs sont préférentiellement égales à 20% près, évitant ainsi un simple écoulement latéral d'un des premier et/ou deuxième composants de la colle bi-composants, et favorisant le mélange. Autrement dit, ledit au moins un premier organe 103 étant recouvert par le premier composant 104 et/ou ledit au moins un deuxième organe 201 étant recouvert par le deuxième composant 202, ledit au moins un premier organe 103 et ledit au moins un deuxième organe 201 présentent des hauteurs sensiblement égales avant l'étape de rapprochement.

En fait, ledit au moins un premier organe 103 et ledit au moins un deuxième organe 201 permettent de former des aspérités qui vont volontairement participer au mélange des premier et deuxième composants 104, 202 de la colle bi-composant au cours de l'étape de rapprochement. Ainsi, au cours de l'étape de rapprochement, le premier organe 103 va préférentiellement contraindre latéralement l'écoulement du premier composant 104 et le deuxième organe 201 va préférentiellement contraindre latéralement l'écoulement du deuxième composant 202 de la colle bi-composants. La contrainte latérale est donnée selon une direction d'écoulement sensiblement perpendiculaire (c'est-à-dire perpendiculaire à plus ou moins 20%) à la direction d'extension des premier et deuxième organes à partir respectivement du premier élément microélectronique et du deuxième élément microélectronique. Ici les directions d'extension des premier et deuxième organes sont orientées de manière opposée lors de l'étape de rapprochement.

Pour obtenir un mélange optimisé, au terme de l'étape de rapprochement illustrée aux figures 3 et 4, la distance d1 séparant le premier élément microélectronique 100 du deuxième élément microélectronique 200 est inférieure à la hauteur cumulée dudit au moins un premier organe 103 et dudit au moins un deuxième organe 201 avant rapprochement. La hauteur cumulée correspond à la somme des hauteurs H1 du premier organe 103 et H2 du deuxième organe 201 visibles aux figures 1 et 3. La hauteur H1 du premier organe 103 est donnée selon la direction dans laquelle s'étend ledit premier organe 103 à partir du premier élément microélectronique 100. De manière analogue, la hauteur H2 du deuxième organe 201 est donnée selon la direction dans laquelle s'étend ledit deuxième organe 201 à partir du deuxième élément microélectronique 200. On comprend alors que chaque premier organe 103 comporte deux extrémités 103a, 103b opposées (figure 1) entre lesquelles s'étend le premier organe 103. Une première extrémité 103a du premier organe 103 est disposée à l'interface du premier organe 103 avec le premier élément microélectronique 100, et une deuxième extrémité 103b du premier organe 103 est distante du premier élément microélectronique 100 (H1 étant alors la distance entre les extrémités 103a et 103b). De la même manière, chaque deuxième organe 201 comporte deux extrémités 201 a, 201 b opposées entre lesquelles s'étend le deuxième organe 201. Une première extrémité 201a du deuxième organe 201 est disposée à l'interface du deuxième organe 201 avec le deuxième élément microélectronique 200, et une deuxième extrémité 201 b du deuxième organe 201 est distante du deuxième élément microélectronique 200 (H2 étant alors la distance entre les extrémités 201 a et 201 b).

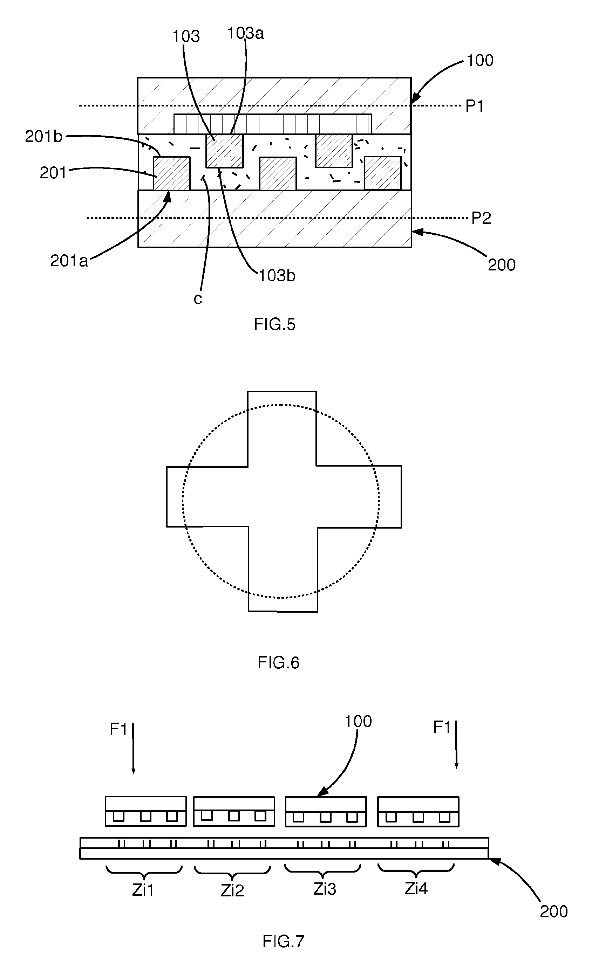

Selon ce qui est visible aux figures 3 et 5, on peut aussi avoir au terme de l'étape de rapprochement le fait que la distance d1 séparant le premier élément microélectronique 100 du deuxième élément microélectronique 200 est inférieure à la hauteur cumulée dudit au moins un premier organe 103 et dudit au moins un deuxième organe 201 après et avant rapprochement. On comprend ici que la hauteur cumulée dudit au moins un premier organe 103 et dudit au moins un deuxième organe 201 peut être différente ou pas selon que l'on se place avant ou après l'étape de rapprochement. Ce cas permet de couvrir à la fois une insertion dudit au moins un premier organe 103 dans ledit au moins un deuxième organe 201, ou inversement, ainsi qu'une mise en vis-à-vis de deux tronçons longitudinaux appartenant respectivement audit au moins un premier organe et audit au moins un deuxième organe.

Selon une cinématique plus détaillée, les zones à coller des premier et deuxième éléments microélectroniques 100, 200 sont placées en regard l'une à l'autre avant de rapprocher le premier élément microélectronique 100 du deuxième élément microélectronique 200. Dans cette phase, si les premier et/ou deuxième organes 103, 201 sont recouverts d'un composant de la colle ou du mélange d'un composant de la colle, ce composant ou ce mélange formant colle peut déjà être évacué. Dans le cas où de la colle est évacuée, il faut noter que l'écoulement peut être assimilé à un écoulement plan/plan. Le mélange des premier et deuxième composants 104, 202 n'a lieu que de manière superficielle à l'interface entre ces premier et deuxième composants 104, 202. Au cours du rapprochement, l'espacement entre les premier et deuxième éléments microélectroniques atteint une valeur h_t avec h_t égal à la somme de la hauteur H1 dudit au moins un premier organe 103 plus la hauteur H2 dudit au moins un deuxième organe 201. Lorsque l'espacement est égal à h_t, le volume des deux composants de la colle présent et restant entre les organes est appelé volume passif. Ce volume est dit passif dans la mesure où il ne participe pas encore au mélange et donc au collage. Ce volume passif deviendra actif, dans le sens où il participera au mélange et ainsi au collage, lorsque qu'une force suffisante est appliquée sur l'un des premier ou deuxième éléments microélectroniques 100, 200 afin de diminuer l'espacement entre le premier élément microélectronique 100 et le deuxième élément microélectronique 200. Le mode d'écoulement de la colle type plan/plan qui pouvait avoir lieu précédemment n'est plus possible et le volume initialement passif est alors contraint à l'écoulement. Ceci permet un mélange par la circulation de la colle entre les organes.

Plus particulièrement, l'étape de rapprochement est stoppée lorsque le rapport de la distance d1 séparant les premier et deuxième éléments microélectroniques 100, 200 sur la hauteur cumulée (H1+H2) dudit au moins un premier organe 103 et dudit au moins un deuxième organe 201 avant rapprochement est, de préférence, inférieur à 0,9, et par exemple compris entre 0,1 et 0,9.

Selon un premier mode d'exécution illustré à la figure 5, le mélange des premier et deuxième composants est réalisé sans contact entre lesdits au moins un premier organe 103 et au moins un deuxième organe 201. En ce sens, après rapprochement, un premier organe 103 et un deuxième organe 201 adjacents sont séparés par de la colle C. Plus particulièrement, le premier organe 103 comporte un tronçon partant de sa deuxième extrémité 103b en direction de sa première extrémité 103a disposé en vis-à-vis d'un tronçon du deuxième organe 201 adjacent partant de sa deuxième extrémité 201 b en direction de sa première extrémité 201 a. Ces deux tronçons sont sensiblement parallèles entre eux et perpendiculaires à un plan parallèle aux plans P1 et P2 incluant respectivement le premier élément microélectronique 100 et le deuxième élément microélectronique 200 (à la figure 5 les plans P1 et P2 sont perpendiculaires au plan dans lequel la figure est réalisée).

Dans ce premier mode d'exécution, selon un perfectionnement, au moins une connexion électrique est réalisée entre le premier élément microélectronique et le deuxième élément microélectronique (perfectionnement non représenté en figure 5). Cette connexion électrique peut être réalisée par ledit au moins un premier organe (ou au moins un des premier organes) qui est alors en contact électrique avec une plage d'accueil métallisée du deuxième élément microélectronique (la plage d'accueil est alors distincte du ou des deuxièmes organes) au terme de l'étape de rapprochement, ou par ledit au moins deuxième organe (ou au moins un des deuxièmes organes) qui est alors en contact électrique avec une plage d'accueil métallisée du premier élément microélectronique (la plage d'accueil est alors distincte du ou des premiers organes) au terme de l'étape de rapprochement. En ce sens, ce perfectionnement dissocie la fonction de mélange dévolue à l'interaction entre le(s) premier(s) organe(s) et le(s) deuxième(s) organe(s) avec les premier et deuxième composants de la colle. Par exemple, la ou les plages métallisées visées dans le présent paragraphe sont des pistes conductrices formées sur une partie de l'élément microélectronique concerné (le premier ou le deuxième). En ce sens, le procédé peut comporter une étape de connexion électrique entre les premier et deuxième éléments microélectroniques par une mise en contact électrique dudit au moins un premier organe avec une plage d'accueil métallisée du deuxième élément microélectronique et/ou par une mise en contact électrique dudit au moins un deuxième organe avec une plage d'accueil métallisée du premier élément microélectronique.

Selon un deuxième mode d'exécution (figures 1 et 3), le mélange des premier et deuxième composants est réalisé avec contact entre lesdits au moins un premier organe 103 et au moins un deuxième organe 201. En ce sens, le procédé comporte une étape d'insertion (figure 2) dudit au moins un premier organe 103 dans ledit au moins un deuxième organe 201 correspondant, ou dudit au moins un deuxième organe 201 dans ledit au moins un premier organe 103 correspondant. Cette insertion est réalisée au cours de l'étape de rapprochement. L'insertion permet de favoriser le déplacement des premier et deuxième composants 104, 202 de la colle bi-composants, et donc leur mélange. Dans ce deuxième mode d'exécution, lesdits au moins un premier organe 103 et/ou au moins un deuxième organe 201 sont recouverts, notamment en tout ou partie, respectivement par le premier composant 104 et le deuxième composant 202.

En particulier, lorsqu'un des organes 103, 201 doit s'insérer dans un autre, l'un d'entre eux présente préférentiellement une ductilité plus importante que l'autre, ceci permettant d'éviter la casse d'organes lors de l'étape d'insertion.

Par exemple, pour favoriser le mélange du premier composant et du deuxième composant dans le cadre de l'insertion de l'un des organe 103, 201 dans un autre organe 201, 103, il est préférable que la profondeur d'insertion soit supérieure à 1µm. La profondeur d'insertion est ici définie par la différence entre les hauteurs cumulées des premier et deuxième organes et la distance finale d1 entre les deux éléments microélectroniques 100, 200. L'étape de rapprochement peut alors être stoppée lorsque la profondeur d'insertion est atteinte.

Dans certaines applications, le premier élément microélectronique100, notamment la puce électronique 101 du premier élément microélectronique 100 peut être amené à être connecté électriquement au deuxième élément microélectronique 200, par exemple à une piste conductrice du deuxième élément microélectronique. En ce sens, le procédé comporte avantageusement une étape de connexion électrique dudit au moins un premier organe 103 avec ledit au moins un deuxième organe 201 mise en oeuvre par l'étape d'insertion, préférentiellement ledit au moins un premier organe 103 étant relié électriquement à ladite au moins une puce électronique 101 correspondante du premier élément microélectronique 100. On comprend ici que tout ou partie de chacun desdits au moins un premier organe 103 et au moins un deuxième organe 201 est électriquement conducteur. L'insertion permet alors d'assurer un contact suffisant entre un couple comprenant un premier organe 103 et un deuxième organe 201 de telle sorte à assurer la conduction électrique recherchée. Ledit au moins un deuxième organe 201 peut alors être relié électriquement à un dispositif du deuxième élément microélectronique 200, ce dispositif pouvant être une autre puce électronique, ou un réseau de pistes électriquement conductrices. Toujours dans le but d'améliorer le mélange lors de l'étape de rapprochement, au moins l'un des premier ou deuxième organe 103, 201 comporte un corps creux (dans l'exemple particulier des figures 1 et 3, il s'agit du deuxième organe 201) rempli par le composant (le deuxième composant 202 dans l'exemple) correspondant de la colle (premier composant si le corps creux appartient au premier organe, ou deuxième composant si le corps creux appartient au deuxième organe). Le procédé comporte alors une étape d'expulsion d'au moins une partie dudit composant correspondant de la colle hors du corps creux mise en oeuvre au cours de l'étape d'insertion. Cette expulsion permet d'améliorer le mélange des premier et deuxième composants 104, 202 de la colle bi-composants.

Le corps creux peut être un tube présentant une ouverture à une extrémité de l'organe distante de l'élément à partir duquel s'étend ledit organe.

Pour que cette mise en oeuvre de l'expulsion soit possible, tout ou long du rapprochement, le corps creux conserve préférentiellement une ouverture non bouchée par l'autre organe. Dès lors, l'insertion est telle que la pression dans le corps creux augmente de sorte à permettre l'expulsion du composant correspondant par ladite ouverture non bouchée. Le corps creux peut présenter tout type de forme pour permettre cette expulsion. La figure 6 illustre notamment un organe creux présentant une section, perpendiculaire à sa direction d'extension par rapport à l'élément à partir duquel il s'étend, dont le profil général est une ligne fermée en forme de croix. L'autre organe, de préférence plein, destiné à coopérer avec l'organe dont la section est de profil en forme de croix présente alors une section (représentée en pointillés) dont les dimensions sont inférieures à celles de l'organe en forme de croix. Alternativement, les premier et deuxième éléments microélectroniques 100, 200 sont alignés de sorte que les premier et deuxième organes 103, 201 destinés à coopérer entre eux soient désaxés pour que le, ou les, corps creux ne soient pas bouché(s) lors du rapprochement.

Préférentiellement et applicable à tout ce qui a été dit ci-dessus, le premier élément microélectronique 100 comporte une pluralité de premiers organes 103 recouverts par le premier composant 104 et le deuxième élément microélectronique 200 comporte une pluralité de deuxièmes organes 201 recouverts par le deuxième composant 202. L'étape de mélange est telle que les premier et deuxième composants 104, 202 se mélangent par écoulement forcé (réalisant ainsi un micromélange) au travers d'obstacles formés par les premier organes 103 et les deuxièmes organes 201.

En particulier, pour favoriser le mélange, au moins trois microstructures s'étendent du premier élément microélectronique et au moins trois microstructures s'étendent du deuxième élément microélectronique. Ces microstructures seront utilisées comme mélangeur. Typiquement trois premiers organes forment les trois microstructures associées au premier élément microélectronique et trois deuxièmes organes forment les trois microstructures associées au deuxième élément microélectronique. Pour chacun des premier et deuxième éléments microélectroniques une zone locale est définie comme la zone contenant au moins trois de ces microstructures. Dans le cas où l'assemblage contient plus de trois microstructures utilisées comme mélangeur, la zone locale n'est pas définie de manière unique. Chaque zone locale répond à l'équation suivante : eA_i + eB_i > h_f,

Où eA_i ; eB_i et h_f sont définies dans la zone locale par :
- eA_i : l'épaisseur initiale moyenne du premier composant dans le cas où ce dernier est sous forme de film continu. Dans le cas où le film est discontinu, eA_i est définie comme l'épaisseur initiale moyenne que formerait un film continu de même volume.
- eB_i: l'épaisseur initiale moyenne du deuxième composant dans le cas où le deuxième composant est sous forme de film continu. Dans le cas où le film est discontinu, eB_i est définie comme l'épaisseur initiale moyenne que formerait un film continu de même volume.
- h_f : espacement entre les premier et deuxième éléments microélectroniques, après assemblage (c'est-à-dire après rapprochement).

Selon une réalisation, le procédé comporte une étape de chauffage mise en oeuvre au cours de (ou avant) l'étape de rapprochement, et configurée de sorte à modifier la viscosité du premier composant 104 et/ou du deuxième composant 202. Cette modification de la viscosité permet notamment de fluidifier le premier composant 104 et/ou le deuxième composant 202 de la colle bi-composants de sorte à améliorer le mélange. L'homme du métier sera alors à même de déterminer la température nécessaire en fonction des composants de la colle bi-composants.

Le premier composant 104 peut se présenter sous la forme d'un film continu, ou discontinu, formé sur la face 105 du premier élément microélectronique 100 à partir de laquelle s'étend ledit au moins un premier organe 103. Il en va de même pour le deuxième composant 201 qui peut se présenter sous la forme d'un film continu, ou discontinu, formé sur la face 203 du deuxième élément microélectronique 200 à partir de laquelle s'étend ledit au moins un deuxième organe 201 (figure 1).

Le premier élément microélectronique 100, et le deuxième élément microélectronique 200, étant issu(s) de la filière microélectronique, il a fallu développer des techniques permettant de former le premier composant 104 et le deuxième composant 202 sans préjudice à l'élément associé.

En ce sens, le procédé peut comporter une étape de formation du premier composant 104 et une étape de formation du deuxième composant 202.

En particulier, l'étape de formation du premier composant 104 comporte : une étape de formation d'un mélange dudit premier composant 104 avec un solvant inerte vis-à-vis dudit premier composant 104 ; une étape de dépôt du mélange sur le premier élément microélectronique 100 ; une étape d'évaporation du solvant compris dans le mélange déposé. Alternativement, le dépôt peut être réalisé par évaporation. Le solvant ici décrit peut être optionnel.

Selon un mode d'exécution particulier, le premier composant 104 est un catalyseur de la colle bi-composants. Dans ce cas, l'étape de formation du premier composant 104 est préférentiellement telle que le catalyseur est mélangé à un solvant choisi de telle façon que ledit catalyseur soit soluble dans ce solvant. La solution obtenue est préférentielle déposée au spray sur le premier élément microélectronique 100, et en particulier sur le premier élément microélectronique 100 comportant une pluralité de puces électroniques. Bien que ce dépôt soit préféré, d'autres types de dépôts peuvent être envisagés comme le dépôt à la tournette (technique aussi connue sous le terme anglais « spin coating »), la sérigraphie (technique aussi connue sous le terme anglais « Screen printing »), le dépôt jet d'encre, le dépôt à la goutte, la lamination, etc. L'épaisseur déposée est ajustée en fonction du pourcentage volumique de solvant dans la solution et des paramètres de dépôt (temps, vitesse et fréquence de balayage, vitesse de rotation). La gamme d'épaisseur rencontrée en impression s'étend de 1µm à 50µm. Les technique de dépôt par jet d'encre ou sérigraphie permettent de déposer de 1 µm à 10µm. L'épaisseur typiquement déposée pour une application d'hybridation en microélectronique varie classiquement entre 1µm et 3µm.

De manière similaire, l'étape de formation du deuxième composant 201 comporte : une étape de formation d'un mélange dudit deuxième composant 202 avec un solvant inerte vis-à-vis dudit deuxième composant 202 ; une étape de dépôt du mélange sur le deuxième élément microélectronique 200 ; une étape d'évaporation du solvant compris dans le mélange déposé. Alternativement, le dépôt peut être réalisé par évaporation. Le solvant ici décrit peut être optionnel.

Dans le cadre où le premier composant 104 est le catalyseur visé ci-dessus, le deuxième composant 202 est de la résine. Dans ce cas, l'étape de formation du deuxième composant 202 est préférentiellement telle que la résine est mélangée à un solvant choisi de telle façon que ladite résine soit soluble dans ce solvant et que les fonctions réactives des chaînes époxy ne soient pas affectées. La solution obtenue est préférentielle déposée à la tournette (technique aussi connue sous le terme anglais « spin coating ») sur le deuxième élément microélectronique 200. Bien que ce dépôt soit préféré, d'autres types de dépôts peuvent être envisagés comme le dépôt par spray, la sérigraphie (technique aussi connue sous le terme anglais « Screen printing »), le dépôt jet d'encre, le dépôt à la goutte, la lamination, etc. L'épaisseur déposée est ajustée en fonction du pourcentage volumique de solvant dans la solution et des paramètres de dépôt (temps et vitesse de rotation). L'épaisseur typiquement déposée varie entre 1µm et 3µm mais peut être bien plus élevée). La gamme d'épaisseur rencontrée en impression s'étend de 1µm à 50µm. Les technique de dépôt par jet d'encre ou sérigraphie permettent de déposer de 1µm à 10µm. L'épaisseur typiquement déposée pour une application d'hybridation en microélectronique varie classiquement entre 1µm et 3µm.

Il a été décrit ci-dessus à titre d'exemple un premier composant 104 de type catalyseur et un deuxième composant 202 de type résine. Bien entendu l'inverse est aussi possible.

L'étape d'évaporation peut être mise en oeuvre par un cycle thermique appliqué au mélange déposé. Par cycle thermique, on entend qu'un apport de calories est réalisé de sorte à accélérer la réaction d'évaporation du solvant. Par exemple le cycle thermique est tel que le premier élément microélectronique 100 et le deuxième élément microélectronique 200 sont placés dans une enceinte (séparément ou ensemble) à 80°C pendant 30 min.

L'avantage de ces étapes de formation du premier composant et du deuxième composant est que le premier élément microélectronique et le deuxième élément microélectronique peuvent ensuite être stockés pendant une durée importante avant de les utiliser (c'est-à-dire avant de réaliser l'étape de rapprochement telle que décrite ci-avant).

On observe sur le produit obtenu à partir du procédé ci-dessus décrit, une meilleure homogénéisation de l'adhésif sur le pourtour de la couche qu'en son centre avec pour effet de renforcer l'adhérence périphérique entre composants.

Selon un mode d'exécution le deuxième élément microélectronique 200 comporte une pluralité de zones d'hybridation Zi1, Zi2, Zi3, Zi4 (figure 7). Chaque zone d'hybridation Zi1, Zi2, Zi3, Zi4 est destinée à recevoir un élément unitaire faisant par exemple office de premier élément microélectronique 100 et comportant préférentiellement une unique puce électronique. Dans ce cas, le procédé comporte une étape d'association d'une pluralité de premiers éléments 100 à un même deuxième élément microélectronique 200 par exemple en utilisant une méthode de « pick and place ». Chaque premier élément microélectronique 100 est tel que décrit ci-avant, et l'étape de rapprochement (par exemple selon les flèches F1) aura pour conséquence d'hybrider chaque premier élément microélectronique 100 avec le deuxième élément microélectronique 200 associé d'une manière telle que décrite ci-avant. L'étape de rapprochement peut être mise en oeuvre concomitamment, ou non, pour chacun des premiers éléments 100.

Alternativement, le deuxième élément microélectronique 200 comporte une pluralité de zones d'hybridation Zi1, Zi2, Zi3, Zi4 (figure 2). Chaque zone d'hybridation Zi1, Zi2, Zi3, Zi4 est destinée à recevoir un élément unitaire appartenant à l'élément 100 comprenant des puces électroniques individualisées ou non. Chaque élément unitaire comporte ici préférentiellement une unique puce électronique

De manière générale applicable à tout ce qui a été dit ci-dessus, après l'étape de rapprochement, le procédé peut comporter une étape de réticulation du mélange des premier et deuxième composants 104, 202 de la colle bi-composants. Cette étape peut être réalisée à température ambiante (c'est-à-dire à 25°C par exemple pendant une durée adaptée typiquement de 2 heures à 72 heures), ou par mise en oeuvre d'une étape de recuit du mélange des premier et deuxième composants 104, 202. Le recuit consiste en la réticulation du mélange bi-composant, par la création d'un réseau moléculaire solide en 3 dimensions. Concernant les valeurs de température associées à des temps donnés, cela varie en fonction de la référence de la colle utilisée. Le recuit peut être réalisé par l'utilisation de différents moyens existants tels qu'une plaque chauffante ou une étuve.

Selon un perfectionnement, il est possible de retirer des portions de premier composant et/ou de deuxième composant n'ayant pas été mélangés et non situés entre un premier élément microélectronique et un deuxième élément microélectronique. Typiquement, dans le mode de réalisation où les premiers éléments sont formés par des puces électroniques individualisées hybridées sur un même deuxième élément microélectronique, le premier élément microélectronique est recouvert du deuxième composant n'ayant pas réagi entre deux puces électroniques. En ce sens un simple nettoyage au solvant peut permettre de retirer les portions de deuxième composant situées entre deux puces adjacentes hybridées sur le même premier élément microélectronique.

La colle décrite ci-dessus peut être de la colle époxy. Dans le cas de l'époxy, le ratio volumique entre le premier composant et le deuxième composant est préférentiellement proche de 1 (il peut toutefois aller jusqu'à 1 :100).

Il a été évoqué précédemment que le premier composant 104 et/ou le deuxième composant 202 pouvaient se présenter sous la forme d'un film continu ou discontinu. Dans le cas où les ratios de volume entre le premier composant 104 et le deuxième composant 202 seraient trop importants (par exemple 1:10 ou 1:20), le composant disposant de la part volumique la plus faible peut ne pas former une couche continue.

Selon une mise en oeuvre très particulière, la hauteur de chaque premier organe formant un plot est de 2.5µm, la hauteur de chaque deuxième organe formant un tube creux est de 2.1µm. Préférentiellement, les plots et tubes sont disposés de manière matricielle avec un pas de 10µm sur une matrice de 320 x 250 connexions (on peut imaginer des matrices plus grandes ou plus petites, par exemple 640x500 ; 150x120 ; 15x20 ...). La force appliquée lors du rapprochement est de l'ordre de 0.5g/connexion. On obtient une hauteur cumulée de = 2.5 + 2.1 = 4.6µm et une distance d1 de 3µm, soit un rapport de 0.65 dans ce cas.

Selon une autre mise en oeuvre très particulière, la hauteur de chaque premier organe formant un plot est de 2.6µm, la hauteur de chaque deuxième organe formant un tube creux est de 2.8µm. Préférentiellement, les plots et tubes sont disposés de manière matricielle avec un pas de 10µm sur une matrice de 320 x 250 connexions (on peut imaginer des matrices plus grandes ou plus petites, par exemple 640x500 ; 150x120 ; 15x20 ...). La force appliquée lors du rapprochement est de l'ordre de 1g/connexion. On obtient une hauteur cumulée de = 2.6 + 2.8 = 5,4µm et une distance d1 de 4.8µm, soit un rapport de 0.88 dans ce cas.

Chacune des puces peut comporter une diode électroluminescente. Grâce à ce procédé, il devient aisé de former des panneaux d'affichage robustes muni d'une pluralité de diodes électroluminescentes. Selon une autre réalisation, chacune des puces peut être du type utilisé dans le domaine de la haute densité (par exemple microcontrôleur) ou dans le domaine des puces de puissance. Selon un exemple, une puce utilisée dans le cadre de l'invention permettrait de disposer d'un circuit de modulation de commande de transistors de puissance (GaN) au plus près d'une jonction de puissance, en particulier pour une application d'alimentation de moteur(s).

Selon une mise en oeuvre particulière, les enseignements de la demande de brevet FR2977370 peuvent être appliqués. Dans ce cas, l'un desdits au moins un premier organe ou au moins un deuxième organe est un plot et l'autre desdits au moins un premier organe ou au moins un deuxième organe est un insert tels que décrits dans ladite demande de brevet FR2977370.

Par ailleurs, concernant l'insertion évoquée précédemment utilisant un corps creux et permettant la mise en oeuvre de l'étape d'expulsion, les enseignements du document FR2949171 peuvent être avantageusement utilisés.

Selon une variante, ledit au moins un premier organe et/ou ledit au moins un deuxième organe se déforme, notamment par flambage au cours de l'étape de rapprochement. Dans ce cas il n'y a pas d'insertion de l'organe 103 dans l'organe 201 (ou inversement), mais déformation de l'un contre l'autre lors de l'étape de rapprochement.

## Revendications

1. Procédé d'hybridation d'un premier élément microélectronique (100) avec un deuxième élément microélectronique (200), au moins un premier organe (103) s'étendant dudit premier élément microélectronique (100), un premier composant (104) d'une colle bi-composants étant associé audit premier élément microélectronique (100), au moins un deuxième organe (201) s'étendant dudit deuxième élément microélectronique (200), un deuxième composant (202) de la colle bi-composants étant associé audit deuxième élément microélectronique (200), ledit procédé comportant une étape de rapprochement des premier et deuxième éléments microélectroniques (100, 200) de telle sorte à générer un collage par interaction des premier et deuxième composants (104, 202) de la colle bi-composants, **caractérisé en ce qu'**il comporte une étape de mélange des premier et deuxième composants (104, 202) mise en oeuvre par lesdits au moins un premier et deuxième organes (103, 201) lors de l'étape de rapprochement, et **en ce qu'**au terme de l'étape de rapprochement la distance (d1) séparant le premier élément microélectronique (100) du deuxième élément microélectronique (200) est inférieure à la hauteur cumulée dudit au moins un premier organe (103) et dudit au moins un deuxième organe (201) avant rapprochement.

2. Procédé selon la revendication précédente, **caractérisé en ce que** l'étape de rapprochement est stoppée lorsque le rapport de la distance (d1) séparant les premier et deuxième éléments microélectroniques (100, 200) sur la hauteur cumulée dudit au moins un premier organe (103) et dudit au moins un deuxième organe (201) avant rapprochement est inférieur à 0,9, et de préférence compris entre 0,1 et 0,9.

3. Procédé selon l'une des revendications précédentes, **caractérisé en ce que** ledit au moins un premier organe (103) étant recouvert par le premier composant (104) et/ou ledit au moins un deuxième organe (201) étant recouvert par le deuxième composant (202), le procédé comporte une étape d'insertion dudit au moins un premier organe (103) dans ledit au moins un deuxième organe (201) correspondant, ou dudit au moins un deuxième organe (201) dans ledit au moins un premier organe (103) correspondant, ladite étape d'insertion étant réalisée au cours de l'étape de rapprochement.

4. Procédé selon la revendication précédente, **caractérisé en ce qu'**il comporte une étape de connexion électrique dudit au moins un premier organe (103) avec ledit au moins un deuxième organe (201) mise en oeuvre par l'étape d'insertion, préférentiellement ledit au moins un premier organe (103) étant relié électriquement à au moins une puce électronique (101) du premier élément microélectronique (100).

5. Procédé selon l'une des revendications 3 ou 4, **caractérisé en ce que** au moins l'un des premier ou deuxième organe (103, 201) comporte un corps creux rempli par le composant correspondant de la colle, et **en ce que** le procédé comporte une étape d'expulsion d'au moins une partie dudit composant correspondant de la colle hors du corps creux mise en oeuvre au cours de l'étape d'insertion.

6. Procédé selon l'une des revendications précédentes, **caractérisé en ce que** le premier élément microélectronique (100) comporte une pluralité de premiers organes (103) recouverts par le premier composant (104) et le deuxième élément microélectronique (200) comporte une pluralité de deuxièmes organes (201) recouverts par le deuxième composant (202), et **en ce que** l'étape de mélange est telle que les premier et deuxième composants (104, 202) se mélangent par écoulement forcé de ces derniers au travers d'obstacles formés par les premiers organes (103) et les deuxièmes organes (201).

7. Procédé selon l'une quelconque des revendications précédentes, **caractérisé en ce qu'**il comporte une étape de chauffage mise en oeuvre avant, ou au cours de, l'étape de rapprochement et configurée de sorte à modifier la viscosité du premier composant (104) et/ou du deuxième composant (202).

8. Procédé selon l'une quelconque des revendications précédentes, **caractérisé en ce qu'**il comporte une étape de formation du premier composant (104) et une étape de formation du deuxième composant (202).

9. Procédé selon la revendication précédente, **caractérisé en ce que** l'étape de formation du premier composant (104) comporte :
- une étape de formation d'un mélange dudit premier composant (104) avec un solvant inerte vis-à-vis dudit premier composant (104),
- une étape de dépôt du mélange sur le premier élément microélectronique (100),
- une étape d'évaporation du solvant compris dans le mélange déposé.

10. Procédé selon la revendication 8, **caractérisé en ce que** l'étape de formation du deuxième composant (202) comporte :
- une étape de formation d'un mélange dudit deuxième composant (202) avec un solvant inerte vis-à-vis dudit deuxième composant (202),
- une étape de dépôt du mélange sur le deuxième élément microélectronique (200),
- une étape d'évaporation du solvant compris dans le mélange déposé.

11. Procédé selon l'une des revendications 9 ou 10, **caractérisé en ce que** l'étape d'évaporation est mise en oeuvre par un cycle thermique appliqué au mélange déposé.

12. Procédé selon l'une quelconque des revendications précédentes, **caractérisé en ce qu'**au terme de l'étape de rapprochement la distance (d1) séparant le premier élément microélectronique (100) du deuxième élément microélectronique (200) est inférieure à la hauteur cumulée dudit au moins un premier organe (103) et dudit au moins un deuxième organe (201) après rapprochement.

13. Procédé selon l'une quelconque des revendications précédentes, **caractérisé en ce que** ledit au moins un premier organe (103) étant recouvert par le premier composant (104) et/ou ledit au moins un deuxième organe (201) étant recouvert par le deuxième composant (202), ledit au moins un premier organe et ledit au moins un deuxième organe présentent des hauteurs sensiblement égales avant l'étape de rapprochement.

14. Procédé selon l'une des revendications précédentes, **caractérisé en ce qu'**il comporte une étape de connexion électrique entre les premier et deuxième éléments microélectroniques par une mise en contact électrique dudit au moins un premier organe avec une plage d'accueil métallisée du deuxième élément microélectronique et/ou par une mise en contact électrique dudit au moins un deuxième organe avec une plage d'accueil métallisée du premier élément microélectronique.
